# EUROPÄISCHE PATENTSCHRIFT

(11) **EP 1 320 022 B1**
(45) Veröffentlichungstag und Bekanntmachung des Hinweises auf die Patenterteilung: **14.05.2008**
(21) Anmeldenummer: 02027148.2
(22) Anmeldetag: 04.12.2002
(51) Int. Cl.: G06F 1/18, H05K 7/14

(54) **Anordnung zur Festlegung eines Slotwinkels**
Device for fixing a bracket in a slot
Dispositif pour le maintien d' une patte dans une fente

(30) Priorität: 14.12.2001 DE 10161504
(43) Veröffentlichungstag der Anmeldung: 18.06.2003
(73) Patentinhaber: Fujitsu Siemens Computers GmbH, 80807 München (DE)
(72) Erfinder: Neukam, Wilhelm, 86399 Bobingen (DE); Müller-Augste, Frank, 86399 Bobingen (DE)
(74) Vertreter: Epping - Hermann - Fischer

(56) Entgegenhaltungen:
- EP-A- 0 816 975
- DE-C- 19 533 063
- DE-U- 20 009 657

## Beschreibung

Die Erfindung betrifft eine Anordnung zur Festlegung eines Slotwinkels, mit im Wesentlichen zwei aufeinander senkrecht stehenden Abschnitten am Slotfeld eines Computergehäuses, wobei ein Abschnitt länger und ein Abschnitt kürzer ausgebildet ist und der kürzere Abschnitt des Slotwinkels durch einen an einer Wandung des Computergehäuses verschiebbar angeordneten Schiebers durch Klemmung gegen eine Seitenwandung des Slotfeldes festlegbar ist.

Bisher war es üblich, Slotwinkel bzw. Slotkarten im Computergehäuse mittels Schrauben festzulegen. Diese haben jedoch den Nachteil, dass sie beim Herabfallen während der Montage bzw. Demontage der Slotwinkel Kurzschlüsse erzeugen können.

Einige Firmen setzen anstatt der Schrauben Zusatzteile aus Kunststoff ein, welche eine Klemmung der Slotwinkel bewirken.

Derartige Lösungen sind z.B. in der WO 97/34216, der DE 195 33 063 C1, der DE 295 20 867 U1 und der DE 196 06 797 C2 beschrieben.

Durch die Zusatzklemmteile ist zwar gewährleistet, dass diese beim Herabfallen keine Kurzschlüsse verursachen, jedoch sind nach wie vor zur Montage der Slotwinkel bzw. Slotkarten getrennte Zusatzteile erforderlich, welche bei der Herstellung einen logistischen Aufwand verursachen und insbesondere beim Kunden immer wieder auch verloren gehen und dann einzeln nachgekauft werden müssen.

Eine weitere Lösung ist von der Firma HP bekannt, bei der eine Metallfeder alle kurzen Abschnitte (Blindwinkel) der Slotwinkel seitlich gegen das Slotfeld presst. Die Metallfeder wird auf der einen Seite eingehängt und auf der anderen Seite verschraubt. Die Slotwinkel sind speziell mit einem Haken am freien Ende des kurzen Abschnittes ausgebildet, welcher ein Herausfallen oder Herausrutschen unter der Metallfeder verhindert.

Auch die Firma Dell verwendet ein Konzept, bei welchem alle kurzen Abschnitte der Slotwinkel seitlich gegen das Slotfeld gepreßt werden. Hierzu ist an der Seite des Slotfeldes ein um eine Drehachse schwenkbarer Hebel vorgesehen, welcher durch das Schließen des Gehäuses gegen die kurzen Abschnitte der Slotwinkel gepreßt wird.

Die Slotwinkel sind ebenso wie bei der Lösung von HP mit Haken versehen, welche ein Herausrutschen unter dem Hebel verhindern.

Die Lösung von Dell hat gegenüber HP den Vorteil, dass keine Teile herabfallen können. Jedoch ist an dieser Lösung ebenso nachteilig, dass nur alle Slotwinkel auf einmal fixiert und zum Wechseln eines Slotwinkels bzw. einer Slotkarte alle gelöst werden müssen. In der Druckschrift DE 200 09 657 U1 ist eine Slotwinkelfixierung offengelegt, bei der die Schieber von oben auf die Abschnitte der senkrecht stehenden Slotwinkel, die zur Verschraubung vorgesehen sind, geschoben werden und diese somit festlegen.

Ein Nachteil sind die losen Schieber, welche man aus oben genannten Gründen vermeiden möchte. Ein weiterer Nachteil besteht darin, dass oberhalb der Steckkarten relativ viel Platz in Anspruch genommen wird, was zu einer Erhöhung der Mindesthöhe des Computergehäuses führt.

Aus der Druckschrift EP 0 816 975 A2 ist eine Slotwinkelfixierung bekannt, bei der zur klemmenden Festlegung des Slotwinkels fluchtend oberhalb des Slotwinkels ein Schieber angeordnet ist, der längs zur Slotwinkellängserstreckung, auf den jeweiligen kurzen Abschnitt der Slotwinkel zu bewegt werden kann und diesen klemmend festlegt.

Diese Anordnung ist an sich sehr vorteilhaft, vor allem verzichtet sie auf lose Bauteile. Ein Problem ist allerdings, daß in Längsrichtung der Steckkarten viel Platz erforderlich ist und diese Anordnung somit nur in sehr hohen Desktops oder mit einer Riser-Card verwendbar ist.

Der Erfindung liegt daher die Aufgabe zu Grunde eine Anordnung zur Festlegung von Slotwinkeln aufzuzeigen, welche auch für Low Profile-Karten in flachen Desktop PCs eingesetzt werden kann.

Diese Aufgabe wir erfindungsgemäß dadurch gelöst, dass die Wandung mit dem verschiebbaren Schieber seitlich der Seitenwandung des Slotfeldes sowie auch seitlich zur Längserstreckung des festzulegenden Slotwinkels angeordnet ist.

Dadurch wird erreicht, dass der Schieber horizontal verschoben wird und mit seinem vorderen Ende im verriegelten Zustand über dem kurzen Abschnitt des Slotwinkels zu liegen kommt.

In einer Weiterbildung der Erfindung ist der Slotwinkel im geschlossenen Zustand des Computergehäuses durch zusätzlichen Druck des Gehäusedeckels auf den Schieber festgelegt. Besonders günstig ist, dass weiterhin die Möglichkeit besteht den Slotwinkel mittels einer Schraube festzulegen.

Ein weiterer Vorteil besteht darin, dass der Schieber sowohl so ausgelegt werden kann, dass jeder Slotwinkel separat festgelegt ist, als auch mehrere Slotwinkel auf einmal festgelegt sind.

Nachfolgend wird die Erfindung anhand eines in den Zeichnungen dargestellten Ausführungsbeispiels erläutert.

In den Zeichnungen zeigen
- Figur 1: in Schrägansicht einen Ausschnitt der Computerwandung mit Schieber für je eine Slotkarte in offener Stellung und
- Figur 2: die Darstellung gemäß Figur 1 in geschlossener Stellung.
- Figur 3: in Schrägansicht einen Ausschnitt der Computerwandung mit Schieber für je zwei Slotkarten in offener Stellung.

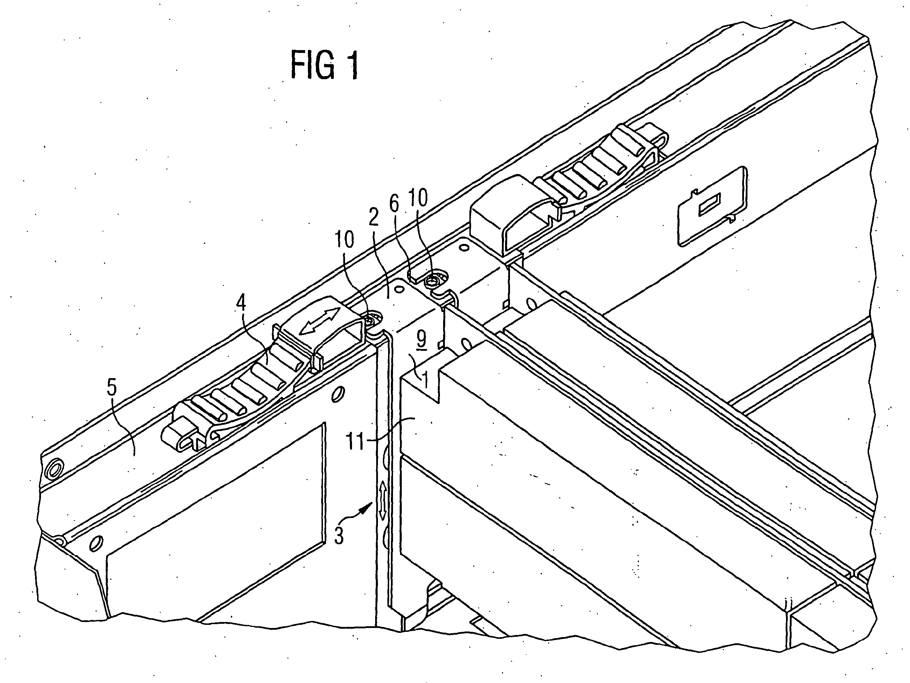

Figur 1 zeigt zwei Schieber 4 in der Wandung 5 eines Computers oder dergleichen, welche zur Festlegung von Slotwinkeln 9 am Slotfeld 3 eines Computers dienen. Die Slotwinkel 9 weisen zwei im wesentlichen aufeinander senkrecht stehende Abschnitte 1 und 2 auf, wobei der kürzere Abschnitt 2, auch Blindwinkel genannt, auf der Seitenwandung 6 des Slotfeldes 3 aufliegt. Im dargestellten Ausführungsbeispiel sind am längeren Abschnitt 1 Slotkarten 11 angebracht, wobei die Schieber 4 auch zur Festlegung von Slotwinkeln 3 alleine dienen.

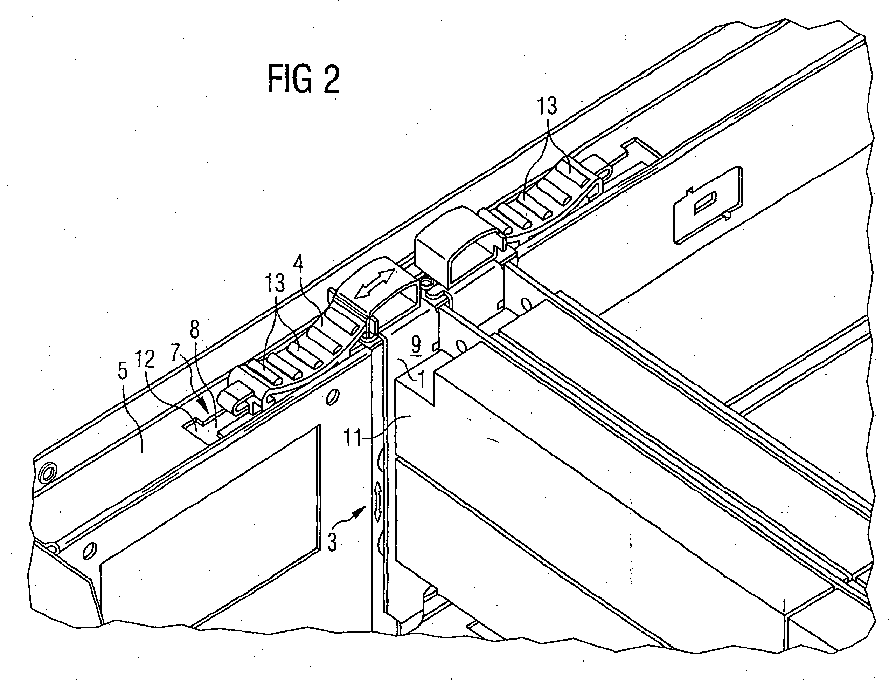

In Figur 1 sind die Schieber in offenem Zustand, so dass die Slotwinkel entnommen werden können, dargestellt. Figur 2 zeigt die Schieber in geschlossenem Zustand, in dem die Slotwinkel festgelegt sind.

Wie aus Figur 2 hervorgeht ist ein Teil der Wandung 5 als Führungsschiene 7 ausgebildet.

In diesem Ausführungsbeispiel ist dies durch einen T-förmigen Führungsschlitz 8 in der Wandung 5 realisiert. In diesen greift der untere Teil des Schiebers ein.

Die bewegliche Verbundenheit des Schiebers 4 mit der Wandung 5 wird dadurch gewährleistet, dass der Schieber oberhalb der Wandung 5 breiter ist als der Führungsschlitz 7. Auf Höhe der Wandung 5 ist er ein bisschen schmäler, gerade so, dass er leicht verschoben werden kann und doch nicht wackelt. Unterhalb der Wandung 5 weist er wieder eine Verbreiterung auf, so dass er nicht herausfallen kann.

Damit eine Montage oder Demontage des Schiebers vorgenommen werden kann ist der Führungsschlitz 7 an seinem Ende 12 breiter und länger als der unterhalb der Wandung 5 liegende Teil des Schiebers 4.

Beide Figuren zeigen auf der Oberseite der hinteren Teile der Schieber Querstege 13, durch die ein Abrutschen eines Fingers beim Ändern der Schieberstellung verhindert werden soll.

Der vordere Teil jedes Schiebers 4 liegt oberhalb des Abschnittes 1 des Slotwinkel 9 und dient zu seiner Fixierung.

Dies wird dadurch bewerkstelligt, dass dieser Teil des Schiebers eine Außengeometrie wie ein hohles Rechteck mit nach oben und unten ausgewölbten Seitenwänden aufweist und aus einem verformbaren Material besteht, so das beim Schließen des Schiebers 4 die Wölbung eingedrückt wird und somit eine definierte Federkraft auf den Abschnitt 1 des Slotwinkels 9 ausgeübt wird.

In diesem Ausführungsbeispiel ist der vordere Teil des Schiebers 4, der oberhalb des Abschnittes 1 des Slotwinkels 9 liegt, so ausgebildet, dass bei geschlossenem Gehäusedeckel die Außenwand auf die obere gewölbte Seite des Schiebers drückt. Der Slotwinkel wird dadurch zusätzlich fixiert.

Des Weiteren sind in der Wandung 5 zwei Gewindedurchzüge 10 vorgesehen, damit die Slotwinkel zusätzlich durch eine Schraube festgelegt werden können.

Die erfindungsgemäße Lösung ist beliebig erweiterbar und jeder Slot kann für sich geöffnet und geschlossen werden.
Figur 2 zeigt die Darstellung gemäß Figur 1 in geschlossener Stellung, wobei alle Elemente mit identischen Bezugszeichen versehen sind.

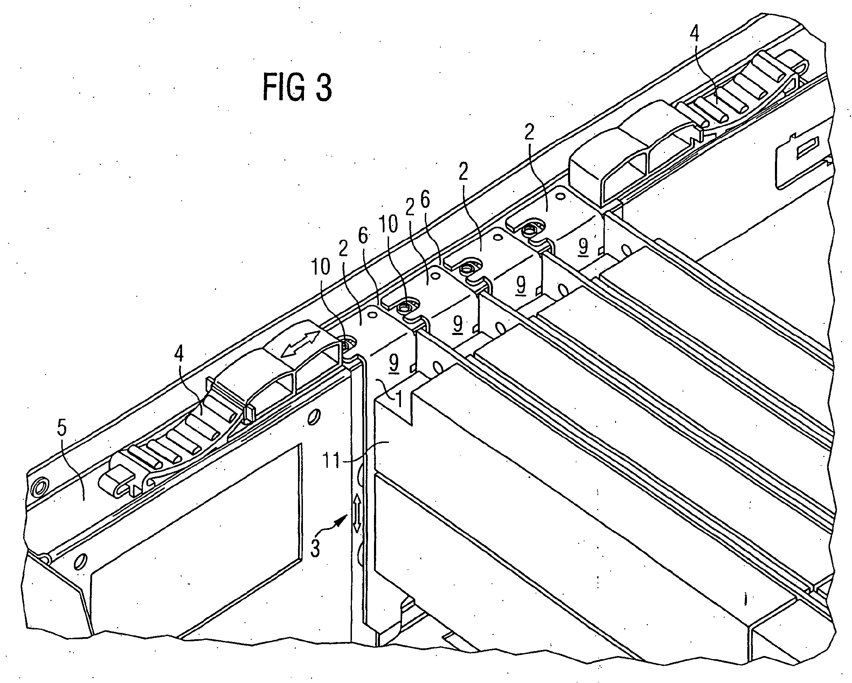

Figur 3 zeigt eine Weiterbildung der Erfindung bei der der Schieber so ausgebildet ist, dass zwei Slotwinkel auf einmal festlegbar sind. Dies kann auch auf noch mehr Slotwinkel ausgeweitet werden.

### Bezugszeichenliste

- 1: Abschnitt des Slotwinkels
- 2: Abschnitt des Slotwinkels (Blindwinkel)
- 3: Slotfeld
- 4: Schieber
- 5: Wandung
- 6: Seitenwandung des Slotfeldes
- 7: Führungsschiene
- 8: Führungsschlitz
- 9: Slotwinkel
- 10: Gewindedurchzug
- 11: Slotkarte
- 12: Ende des Führungsschlitzes
- 13: Quersteg

## Patentansprüche

1. Anordnung zur Festlegung eines Slotwinkels (9) mit im Wesentlichen zwei aufeinander senkrecht stehenden Abschnitten am Slotfeld (3) eines Computergehäuses, wobei ein Abschnitt (1) länger und ein Abschnitt (2) kürzer ausgebildet ist und der kürzere Abschnitt (2) des Slotwinkels (9) durch einen an einer Wandung (5) des Computergehäuses verschiebbar angeordneten Schieber (4) durch Klemmung gegen eine Seitenwandung (6) des Slotfeldes (3) festlegbar ist,
**dadurch gekennzeichnet, dass** die Wandung (5) mit dem verschiebbaren Schieber (4) seitlich der Seitenwandung (6) des Slotfeldes (3) sowie auch seitlich zur Längserstreckung des festzulegenden Slotwinkels (9) angeordnet ist.

2. Anordnung nach Anspruch 1,
**dadurch gekennzeichnet, dass** an der Wandung (5) eine Führungsschiene (7) vorgesehen ist, in die der Schieber (4) eingreift und **dadurch** mit dem Computergehäuse verbunden ist.

3. Anordnung nach Anspruch 2,
**dadurch gekennzeichnet, dass** die Führungsschiene (7) durch einen Führungsschlitz (8) in der Wandung (5) ausgebildet ist.

4. Anordnung nach Anspruch 1 bis 3
**dadurch gekennzeichnet, dass** der Schieber (4) derart ausgestaltet und angeordnet ist, dass bei geschlossenem Computergehäuse durch einen Gehäusedeckel, der parallel zu dem Abschnitt (2) des Slotwinkels (9), der durch den Schieber festgelegt ist, eine Kraft auf den Abschnitt (2) des Slotwinkels (9) einwirkt.

5. Anordnung nach Anspruch 1,
**dadurch gekennzeichnet, dass** ein Gewindedurchzug (10) in der Seitenwandung (6) vorgesehen ist, der zur zusätzlichen Befestigung des Slotwinkels (9) mit einer Schraube am Computergehäuse dient.

6. Anordnung nach einem der Ansprüche 1 bis 5
**dadurch gekennzeichnet, dass** durch einen Schieber (4) mehrere Slotwinkel (9) festlegbar sind.

## Claims

1. Arrangement for fixing a slotted bracket (9) having essentially two sections, which are perpendicular to one another, to the slot panel (3) of a computer housing, one section (1) being longer and one section (2) being shorter, and the shorter section (2) of the slotted bracket (9) being able to be fixed by means of a slide (4), which is displaceably arranged on a wall (5) of the computer housing, by being clamped against a side wall (6) of the slot panel (3),
**characterized in that** the wall (5) with the displaceable slide (4) is arranged to the side of the side wall (6) of the slot panel (3) and also to the side of the longitudinal extent of the slotted bracket (9) to be fixed.

2. Arrangement according to Claim 1,
**characterized in that** a guide rail (7) in which the slide (4) engages and is thus connected to the computer housing is provided on the wall (5).

3. Arrangement according to Claim 2,
**characterized in that** the guide rail (7) is formed by a guide slot (8) in the wall (5).

4. Arrangement according to Claims 1 to 3,
**characterized in that** the slide (4) is configured and arranged in such a manner that, when the computer housing is closed by a housing cover which is parallel to that section (2) of the slotted bracket (9) which is fixed by the slide, a force acts on the section (2) of the slotted bracket (9).

5. Arrangement according to Claim 1,
**characterized in that** an extruded hole (10) which is used to additionally fasten the slotted bracket (9) to the computer housing using a screw is provided in the side wall (6).

6. Arrangement according to one of Claims 1 to 5,
**characterized in that** a plurality of slotted brackets (9) can be fixed using a slide (4).

## Revendications

1. Dispositif pour le maintien d'une patte (9) dans une fente, avec essentiellement deux segments placés perpendiculairement l'un à l'autre sur la zone de la fente (3) d'un boîtier d'ordinateur, dans lequel un segment (1) est plus long et un segment (2) est plus court, et le segment plus court (2) de la patte de fente (9) peut être maintenu par un coulisseau (4) pouvant coulisser sur une paroi (5) du boîtier d'ordinateur par serrage contre une paroi latérale (6) de la zone de la fente (3), **caractérisé en ce que** la paroi (5) avec le coulisseau mobile (4) est disposée latéralement à la paroi latérale (6) de la zone de la fente (3) et aussi latéralement à l'extension longitudinale de la patte de fente (9) à fixer.

2. Dispositif selon la revendication 1, **caractérisé en ce qu'**il est prévu sur la paroi (5) un rail de guidage (7), dans lequel le coulisseau (4) s'engage et est ainsi relié au boîtier d'ordinateur.

3. Dispositif selon la revendication 2, **caractérisé en ce que** le rail de guidage (7) est formé par une fente de guidage (8) dans la paroi (5).

4. Dispositif selon une revendication 1 à 3, **caractérisé en ce que** le coulisseau (4) est conçu et disposé de telle manière que, lorsque le boîtier d'ordinateur est fermé, une force agisse sur le segment (2) de la patte de fente (9) par un couvercle de boîtier, qui est fixé par le coulisseau parallèlement au segment (2) de la patte de fente (9).

5. Dispositif selon la revendication 1, **caractérisé en ce qu'**il est prévu dans la paroi latérale (6) un passage fileté (10), qui sert pour une fixation supplémentaire de la patte de fente (9) au boîtier d'ordinateur avec une vis.

6. Dispositif selon l'une quelconque des revendications 1 à 5, **caractérisé en ce que** plusieurs pattes de fente (9) peuvent être fixées par un coulisseau (4).
